(19) **Europäisches Patentamt / European Patent Office / Office européen des brevets**

(11) **EP 4 564 029 A1**

(12) **EUROPEAN PATENT APPLICATION**
published in accordance with Art. 153(4) EPC

(43) Date of publication:
04.06.2025  Bulletin 2025/23

(51) International Patent Classification (IPC):
$G01R\ 31/367^{(2019.01)}$  $G01R\ 31/389^{(2019.01)}$
$G01R\ 31/396^{(2019.01)}$

(21) Application number: 23939212.9

(22) Date of filing: 26.09.2023

(86) International application number:
PCT/CN2023/121481

(87) International publication number:
WO 2024/244239 (05.12.2024 Gazette 2024/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.05.2023 CN 202310640069

(71) Applicant: Deepal Automobile Technology Co.,
Ltd.
Chongqing 401133 (CN)

(72) Inventors:
• LI, Zonghua
  Chongqing 401135 (CN)
• LI, Dongjiang
  Chongqing 401135 (CN)
• YI, Bingxi
  Chongqing 401135 (CN)

(74) Representative: Petraz, Gilberto Luigi et al
GLP S.r.l.
Viale Europa Unita, 171
33100 Udine (IT)

(54) **BATTERY CELL SOC ESTIMATION METHOD, DEVICE, SERVER, AND STORAGE MEDIUM**

(57)     The present application relates to the technical field of battery management systems, and in particular to a battery cell SOC estimation method, a device, a server, and a storage medium. The method comprises: obtaining an actual internal resistance of a battery cell under any charging condition; using the any charging condition as an index, querying a pre-established internal resistance database, and outputting a reference internal resistance of the battery cell under the any charging condition; calculating an actual capacity and an initial state of charge (SOC) of the battery cell based on the actual internal resistance and the reference internal resistance of the battery cell under the any charging condition, and calculating an actual SOC corresponding to the battery cell during a charging process using the actual capacity and the initial SOC. Therefore, the problems in the existing technology, wherein the SOC calculation method of a battery cell is affected by a battery system and a user's charging conditions and therefore the SOC of a battery cell in a battery pack cannot be accurately calculated, are solved.

FIG. 1

S101 — Obtain an actual internal resistance of the battery cell under any charging condition

S102 — Query a pre-established internal resistance database using the any charging condition as an index to output a reference internal resistance of the battery cell under the any charging condition

S103 — Calculate an actual capacity and an initial SOC of the battery cell based on the actual internal resistance and the reference internal resistance of the battery cell under the any charging condition, and calculate an actual SOC of the battery cell during charging using the actual capacity and the initial SOC

EP 4 564 029 A1

**Description**

## CROSS-REFERENCE TO RELATED APPLICATION

This application is based on and claims priority to Chinese patent application No. 202310640069.X filed on May 31, 2023, the entire contents of which are incorporated herein by reference.

## TECHNICAL FIELD

The present disclosure relates to the field of battery management system technology, and in particular to a method and device for estimating a State of Charge, SOC, of a battery cell, a server, and a storage medium.

## BACKGROUND

Due to differences in capacity of battery cells, variations in SOCs during assembly, and differing rates of degradation among battery cells during use, SOCs of battery cells in a battery pack vary from one to another. The SOC of each battery cell in the battery pack is not only an important parameter for accurately identifying an operation state of each battery cell and calculating a total SOC of the battery pack, but also an important means and basis for a Battery Management System, BMS, to realize refined management.

Currently, there is no mature method to accurately calculate the SOC of a single battery cell in the battery pack. In a conventional technique in the related art, an Open Circuit Voltage, OCV, curve is obtained through combining a Hybrid Pulse Power Characteristic, HPPC, with a low current discharge method, and a SOC is estimated based on a SOC-OCV curve and an Extended Kalman Filter, EKF, algorithm. However, this method, while can be used for estimating the SOC of the single battery cell, cannot be adapted to estimate the SOC of the single battery cell in the battery pack. In another conventional technique in the related art, the SOC of the battery pack is estimated through online identification of characteristic parameters, but this method ignores differences in states of battery cells in the battery pack and treats the calculated SOC of the battery pack as the SOC of the single battery cell.

## SUMMARY

A first objective of the present disclosure is to provide a method for estimating a SOC of a battery cell, to solve a problem of an inability to accurately calculate a SOC of a battery cell in a battery pack due to a fact that a method for calculating the SOC of the battery cell in the related art is affected by a battery system and a charging condition of a user. A second objective of the present disclosure is to provide another method for estimating a SOC of a battery cell. A third objective of the present disclosure is to provide a device for estimating a SOC of a battery cell. A fourth objective of the present disclosure is to provide another device for estimating a SOC of a battery cell. A fifth objective of the present disclosure is to provide a server. A sixth objective of the present disclosure is to provide a computer-readable storage medium.

To realize the above objectives, the present disclosure adopts the following technical solutions.

A method for estimating a SOC of a battery cell is provided. The method is applied in a server and includes: obtaining an actual internal resistance of the battery cell under any charging condition; querying a pre-established internal resistance database using the any charging condition as an index, to output a reference internal resistance of the battery cell under the any charging condition; and calculating an actual capacity and an initial SOC of the battery cell based on the actual internal resistance and the reference internal resistance of the battery cell under the any charging condition, and calculating an actual SOC of the battery cell during charging using the actual capacity and the initial SOC.

According to embodiments of the present disclosure, with the above technical means, the actual capacity and the initial SOC of the battery cell can be calculated through comparing the actual internal resistance of the battery cell with the reference internal resistance of the battery cell, and the actual SOC is calculated based on the actual capacity and the initial SOC. Since the pre-established internal resistance database is used, the reference internal resistance of the battery cell under the any charging condition can be obtained, which prevents a user charging condition and the battery system from affecting a calculation result, and is effectively applicable to various battery systems, realizing an accurate calculation of the SOC of the battery cell.

Further, the calculating the actual capacity and the initial SOC of the battery cell based on the actual internal resistance and the reference internal resistance includes: calculating a root-mean-square error between the actual internal resistance and the reference internal resistance of the battery cell under the any charging condition; and determining an objective function based on the root-mean-square error, and finding an optimal solution to the objective function using a least squares method to obtain the actual capacity and the initial SOC of the battery cell.

According to embodiments of the present disclosure, with the above technical means, the root-mean-square error between the actual internal resistance and the reference internal resistance of the battery cell is calculated. The root-mean-square error is determined as the objective function. The actual capacity and the initial SOC of the battery cell can be accurately calculated using the least squares method.

Further, the calculating the root-mean-square error between the actual internal resistance and the reference internal resistance of the battery cell under the any charging condition includes: establishing an expression for an internal resistance, the SOC, and a capacity of the battery cell; and calculating the root-mean-square error between the actual internal resistance and the reference internal resistance based on the expression.

According to embodiments of the present disclosure, with the above technical means, a relationship among the internal resistance of the battery cell, a charging SOC, and the capacity of the battery cell can be established to calculate the root-mean-square error between the actual internal resistance and the reference internal resistance of the battery cell.

Further, the method further includes, prior to the querying the pre-established internal resistance database: constructing a representational test matrix for temperatures and charging currents; obtaining representational charging curves under different charging conditions based on the representational test matrix, and performing a linear regression processing on the representational charging curves to obtain an electro motive force curve; and calculating overpotential of the battery cell based on the representational charging curves and the electro motive force curve, calculating reference internal resistances under different charging conditions based on the overpotential, and establishing the internal resistance database based on the reference internal resistances under the different charging conditions.

According to embodiments of the present disclosure, with the above technical means, the representational charging curves under the different charging conditions are obtained based on the constructed representational test matrix. A calculation is performed on the representational charging curves using a linear regression algorithm to obtain the electro motive force curve of a battery. The overpotential of the battery cell is calculated based on the representational charging curves and the electro motive force curve. The reference internal resistances are calculated based on the overpotential. The internal resistance database is established, which facilitates subsequent queries for the reference internal resistances under the different charging conditions.

Further, the performing the linear regression processing on the representational charging curves to obtain the electro motive force curve includes: obtaining a maximum charging capacity corresponding to the representational charging curves; determining a stepsize of a capacity interval corresponding to each charging voltage curve based on the maximum charging capacity, and dividing the capacity interval into a plurality of grids based on the stepsize; and calculating, through interpolation and extrapolation, a voltage value in each of the plurality of grids when a current in each of the plurality of grids is a predetermined value, and generating the electro motive force curve subsequent to normalizing all voltage values.

According to embodiments of the present disclosure, with the above technical means, the stepsize of the capacity interval of the charging voltage curve can be determined based on the maximum charging capacity. The capacity interval is divided into the plurality of grids based on the stepsize. The voltage values are calculated through the interpolation and the extrapolation and normalized to obtain the electro motive force curve.

Further, the obtaining the representational charging curves under the different charging conditions based on the representational test matrix includes: discharging to a predetermined cut-off voltage under a first charging condition, and letting stand for a first predetermined duration; discharging to the predetermined cut-off voltage under a second charging condition, recording the representational charging curve, and letting stand for a second predetermined duration; and discharging to the predetermined cut-off voltage under the first charging condition, and performing a charging test under a next charging condition until all charging conditions are tested, to obtain the representational charging curves under the different charging conditions.

According to embodiments of the present disclosure, with the above technical means, the different charging conditions can be tested to obtain the representational charging curves corresponding to the different charging conditions.

Further, the charging condition includes one or more of temperature, charging rate, current, and SOC.

A method for estimating a SOC of a battery cell is provided. The method is applied in a server and includes: constructing a representational test matrix for temperatures and charging currents; obtaining representational charging curves under different charging conditions based on the representational test matrix, and performing a linear regression processing on the representational charging curves to obtain an electro motive force curve; calculating overpotential of the battery cell based on the representational charging curves and the electro motive force curve, calculating reference internal resistances under different charging conditions based on the overpotential, and establishing an internal resistance database based on the reference internal resistances under the different charging conditions; and querying a reference internal resistance of the battery cell under the any charging condition using the internal resistance database, calculating an actual capacity and an initial SOC of the battery cell based on an actual internal resistance and the reference internal resistance of the battery cell under the any charging condition, and calculating an actual SOC of the battery cell during charging using the actual capacity and the initial SOC.

A device for estimating a SOC of a battery cell is provided. The device is applied in a server and includes: an obtaining module configured to obtain an actual internal resistance of a battery cell under any charging condition; an output module configured to query a pre-established internal resistance database using the any charging condition as an index to output a reference internal resistance of the battery cell under the any charging condition; and a first calculation module configured to calculate an actual capacity and an initial SOC of the battery cell based on the actual internal resistance and the reference internal resistance of the battery cell under the any charging condition, and calculate an actual SOC of the battery cell during charging using the actual capacity and the initial SOC.

Further, the first calculation module is further configured to: calculate a root-mean-square error between the actual internal resistance and the reference internal resistance of the battery cell under the any charging condition; and determine an objective function based on the root-mean-square error, and finding an optimal solution to the objective function using a least squares method to obtain the actual capacity and the initial SOC of the battery cell.

Further, the first calculation module is further configured to: establish an expression for an internal resistance, the SOC, and a capacity of the battery cell; and calculate the root-mean-square error between the actual internal resistance and the reference internal resistance based on the expression.

Further, the device further includes a third calculation module. The third calculation module is configured to, prior to the querying the pre-established internal resistance database: construct a representational test matrix for temperatures and charging currents; obtain representational charging curves under different charging conditions based on the representational test matrix, and perform a linear regression processing on the representational charging curves to obtain an electro motive force curve; and calculate overpotential of the battery cell based on the representational charging curves and the electro motive force curve, calculate reference internal resistances under different charging conditions based on the overpotential, and establish the internal resistance database based on the reference internal resistances under the different charging conditions.

Further, the third calculation module is further configured to: obtain a maximum charging capacity corresponding to the representational charging curves; determine a stepsize of a capacity interval corresponding to each charging voltage curve based on the maximum charging capacity, and divide the capacity interval into a plurality of grids based on the stepsize; and calculate, through interpolation and extrapolation, a voltage value in each of the plurality of grids when a current in each of the plurality of grids is a predetermined value, and generate the electro motive force curve subsequent to normalizing all voltage values.

Further, the third calculation module is further configured to: discharge to a predetermined cut-off voltage under a first charging condition, and let stand for a first predetermined duration; discharge to the predetermined cut-off voltage under a second charging condition, record the representational charging curve, and let stand for a second predetermined duration; and discharge to the predetermined cut-off voltage under the first charging condition, and perform a charging test under a next charging condition until all charging conditions are tested, to obtain the representational charging curves under the different charging conditions.

Further, the charging condition includes one or more of temperature, charging rate, current, and SOC.

A device for estimating a SOC of a battery cell is provided. The device is applied in a server and includes: a construction module configured to construct a representational test matrix for temperatures and charging currents; a processing module configured to obtain representational charging curves under different charging conditions based on the representational test matrix, and perform a linear regression processing on the representational charging curves to obtain an electro motive force curve; an establishing module configured to calculate overpotential of the battery cell based on the representational charging curves and the electro motive force curve, calculate reference internal resistances under different charging conditions based on the overpotential, and establish an internal resistance database based on the reference internal resistances under the different charging conditions; and a second calculation module configured to query a reference internal resistance of the battery cell under the any charging condition using the internal resistance database, calculate an actual capacity and an initial SOC of the battery cell based on an actual internal resistance and the reference internal resistance of the battery cell under the any charging condition, and calculate an actual SOC corresponding to the battery cell during charging using the actual capacity and the initial SOC.

A server is provided. The server includes: a memory; a processor; and a computer program stored in the memory and executable on the processor. The processor, when executing the computer program, implements the method for estimating the SOC of the battery cell according to any of the above embodiments.

A computer-readable storage medium is provided. The computer-readable storage medium stores a computer program. The computer program, when executed by a processor, implements the method for estimating the SOC of the battery cell according to any of the above embodiments.

The present disclosure can provide the following advantageous effects.

(1) According to the embodiments of the present disclosure, the actual capacity and the initial SOC of the any battery cell can be calculated through comparing the actual internal resistance of the battery cell with the reference internal resistance of the battery cell, and the actual SOC is calculated based on the actual capacity and the initial SOC. Since the pre-established internal resistance database is used, the reference internal resistance of the battery cell under the any charging condition can be obtained, which prevents the user charging condition and the battery system from affecting the calculation result, and is effectively applicable to various battery systems, realizing the accurate calculation of the SOC of the battery cell.

(2) According to the embodiments of the present disclosure, the root-mean-square error between the actual internal resistance and the reference internal resistance of the battery cell is calculated. The root-mean-square error is determined as the objective function. The actual capacity and the initial SOC of the battery cell can be accurately calculated using the least squares method.

(3) According to the embodiments of the present disclosure, the relationship among the internal resistance of the battery cell, the charging SOC, and the capacity of the battery cell can be established to calculate the root-mean-square error between the actual internal resistance and the reference internal resistance of the battery cell.

(4) According to the embodiments of the present disclosure, the representational charging curves under the different charging conditions are obtained based on the constructed representational test matrix. The calculation is performed on the representational charging curves using the linear regression algorithm to obtain the electro motive force curve of the battery. The overpotential of the battery cell is calculated based on the representational charging curves and the electro motive force curve. The reference internal resistances are calculated based on the overpotential. The internal resistance database is established, which facilitates the subsequent queries for the reference internal resistances under the different charging conditions.

(5) According to the embodiments of the present disclosure, the stepsize of the capacity interval of the charging voltage curve can be determined based on the maximum charging capacity. The capacity interval is divided into the plurality of grids based on the stepsize. The voltage values are calculated through the interpolation and the extrapolation and normalized to obtain the electro motive force curve.

(6) According to the embodiments of the present disclosure, the different charging conditions can be tested to obtain the representational charging curves corresponding to the different charging conditions.

Additional aspects and advantages of the present disclosure will be provided at least in part in the following description, or will become apparent at least in part from the following description, or can be learned from practicing of the present disclosure.

## BRIEF DESCRIPTION OF DRAWINGS

FIG. 1 is a flowchart of a method for estimating a SOC of a battery cell according to an embodiment of the present disclosure.

FIG. 2 is a schematic diagram of representational charging curves under different charging current conditions according to an embodiment of the present disclosure.

FIG. 3 illustrates representational charging curves and an electro motive force curve that are obtained subsequent to normalization according to an embodiment of the present disclosure.

FIG. 4 illustrates a charging current curve and a corresponding voltage curve of an LFP battery cell under an actual charging condition according to an embodiment of the present disclosure.

FIG. 5 is a flowchart of a method for estimating a SOC of a battery cell according to an embodiment of the present disclosure.

FIG. 6 illustrates charging voltage curves obtained under different charging current conditions according to an embodiment of the present disclosure.

FIG. 7 illustrates representational charging curves and an electro motive force curve that are obtained subsequent to normalization according to an embodiment of the present disclosure.

FIG. 8 illustrates internal resistance curves of an LFP battery at 20°C under different current conditions according to an embodiment of the present disclosure.

FIG. 9 illustrates a charging current curve and a corresponding voltage curve of an LFP battery pack under an actual charging condition according to an embodiment of the present disclosure.

FIG. 10 illustrates a variation range of a SOC value of each battery cell and corresponding voltage variation curves during actual charging of an LFP battery pack according to an embodiment of the present disclosure.

FIG. 11 is a flowchart of a method for estimating a SOC of a battery cell according to another embodiment of the present disclosure.

FIG. 12 is an example diagram of a device for estimating a SOC of a battery cell according to an embodiment of the present disclosure.

FIG. 13 is a schematic diagram of a device for estimating a SOC of a battery cell according to another embodiment of the present disclosure.

FIG. 14 is a block diagram showing a structure of a server according to an embodiment of the present disclosure.

## DESCRIPTION OF THE EMBODIMENTS

Embodiments of the present disclosure will be described below with reference to accompanying drawings and preferred embodiments. Other advantages and functions of the present disclosure can be readily appreciated by those skilled in the art from what is disclosed in this specification. The present disclosure can also be implemented or applied through other different specific embodiments. Various details in this specification can also be modified or changed based on different views and applications without departing from the spirit of the present disclosure. It should be understood that the preferred embodiments are only for the purpose of illustrating the present disclosure, rather than limiting the protection scope of the present disclosure.

It should be noted that figures provided in the following embodiments illustrate the basic concept of the present disclosure in a schematic manner only. The figures only illustrate components related to the present disclosure and are not drawn in accordance with the quantity, shape, and size of components in an actual implementation. The shape, quantity, and proportion of the components in the actual implementation can be changed arbitrarily. A layout of the components can be more complex.

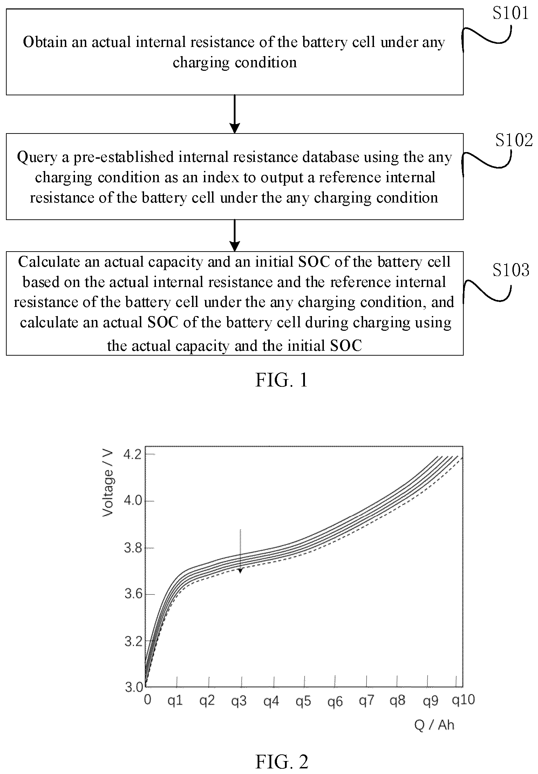

Specifically, FIG. 1 is a schematic flowchart of a method for estimating a SOC of a battery cell according to an embodiment of the present disclosure.

As illustrated in FIG. 1, the method for estimating the SOC of the battery cell is applied in a server and includes following steps.

In step S101, obtain an actual internal resistance of the battery cell under any charging condition.

The battery cell may be any battery cell, such as a battery cell in an LFP battery pack, a battery cell in an NiMH battery, and a battery cell in a Li-ion battery. The charging condition includes one or more of temperature, charging rate, current, and SOC.

In step S102, query a pre-established internal resistance database using the any charging condition as an index to output a reference internal resistance of the battery cell under the any charging condition.

The internal resistance database stores a relationship between charging conditions and reference internal resistances (standard internal resistances). Specific steps for establishing the internal resistance database are described in the following embodiments.

It should be understood that, according to the embodiments of the present disclosure, by querying the pre-established internal resistance database with the charging condition, the reference internal resistance corresponding to the charging condition can be obtained, which facilitates a subsequent calculation of the actual capacity and the initial charging state of the battery cell.

In an embodiment of the present disclosure, the method further includes, prior to the querying the pre-established internal resistance database: constructing a representational test matrix for temperatures and charging currents; obtaining representational charging curves under different charging conditions based on the representational test matrix, and performing a linear regression processing on the representational charging curves to obtain an electro motive force curve; and calculating overpotential of the battery cell based on the representational charging curves and the electro motive force curve, calculating reference internal resistances under different charging conditions based on the overpotential, and establishing the internal resistance database based on the reference internal resistances under the different charging conditions.

The representational test matrix is constructed from two dimensions of temperature and charging current, as specifically illustrated in Table 1, which is a table of representational test matrix.

Table 1

| Temperatur e | T1 | T2 | T3 | T4 | T5 | T6 | T7 | T8 |
|---|---|---|---|---|---|---|---|---|
| Charging current | I11 | I12 | I13 | I14 | I15 | I16 | I17 | I18 |
| | I21 | I22 | I23 | I24 | I25 | I26 | I27 | I28 |
| | I31 | I32 | I33 | I34 | I35 | I36 | I37 | I38 |
| | I41 | I42 | I43 | I44 | I45 | I46 | I47 | I48 |
| | I51 | I51 | I51 | I51 | I51 | I51 | I51 | I51 |
| | I61 | I61 | I61 | I61 | I61 | I61 | I61 | I61 |
| Discharging current | I01 | I02 | I03 | I04 | I05 | I06 | I07 | I08 |

It should be understood that, according to the embodiments of the present disclosure, the representational test matrix can be constructed from two dimensions of temperature and charging current. The representational charging curves under conditions such as different temperatures, charging rates, currents, and SOCs are obtained using the representational test matrix. The linear regression processing is performed on the representational charging curves to obtain the electro motive force curve. The reference internal resistances of the battery cell under the conditions such as different temperatures, charging rates, currents, and SOCs are calculated using the overpotential to establish the internal resistance database.

In an embodiment of the present disclosure, the obtaining the representational charging curves under the different charging conditions based on the representational test matrix includes: discharging to a predetermined cut-off voltage under a first charging condition, and letting stand for a first predetermined duration; discharging to the predetermined cut-off voltage under a second charging condition, recording the representational charging curve, and letting stand for a second predetermined duration; and discharging to the predetermined cut-off voltage under the first charging condition, and performing a charging test under a next charging condition until all charging conditions are tested, to obtain the representational charging curves under the different charging conditions.

The first charging condition, the second charging condition, the first predetermined duration, and the second predetermined duration can be set as desired. The present disclosure is not limited in this regard.

For example, for representational charging at temperature $T_1$, a test method is as follows.

1. Discharge with a constant current I01 to a cut-off voltage.
2. Let stand for 1 hour.
3. Charge with a constant current I11 to the cut-off voltage, and record a voltage curve.
4. Let stand for 1 hour.
5. Discharge with the constant current I01 to the cut-off voltage.
6. Let stand for 1 hour.
7. Repeat steps 1 to 7, using charging currents I21, I31, I41, I51, and I61 sequentially.

The representational charging curves obtained under the different charging current conditions are illustrated in FIG. 2.

In an embodiment of the present disclosure, the performing the linear regression processing on the representational charging curves to obtain the electro motive force curve includes: obtaining a maximum charging capacity corresponding to the representational charging curves; determining a stepsize of a capacity interval corresponding to each charging voltage curve based on the maximum charging capacity, and dividing the capacity interval into a plurality of grids based on the stepsize; and calculating, through interpolation and extrapolation, a voltage value in each of the plurality of grids when a current in each of the plurality of grids is a predetermined value, and generating the electro motive force curve subsequent to normalizing all voltage values.

A charging capacity of a battery is inversely proportional to a charging current of the battery. That is, a minimum charging current corresponds to a maximum charging capacity. The charging capacity is denoted as $q_{max}$.

It should be understood that, according to the embodiments of the present disclosure, the electro motive force curve of the battery is obtained through performing a calculation on the representational charging curves under the different charging conditions using a linear regression algorithm. A specific calculation method is as follows.

Curves in FIG. 2 are divided into 100 grids based on a maximum capacity. Each grid has a width $\Delta q = q_{max}/100$. In each grid, the voltage and the current satisfy the following relationship:

$$AI+B=V, \quad (1)$$

Coefficients in equation (1) are solved using a numerical method. Voltage values when the current is 0 are calculated through interpolation and extrapolation. These voltage values are connected to obtain a curve illustrated by a dotted line in FIG. 2. The dotted line is the electro motive force, EMF, curve of the battery. The EMF curve corresponds to a maximum capacity value, which is denoted as $Q_{max}$.

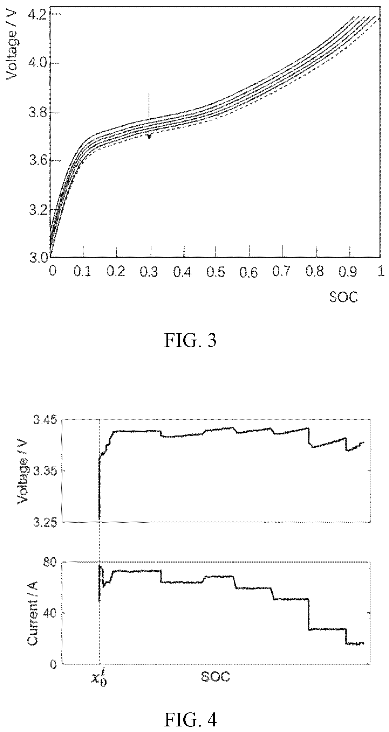

The curves in FIG. 2 are normalized based on the maximum charging capacity, in such a manner that V~Q curves are converted to V~SOC curves, as illustrated in FIG. 3. A method for converting horizontal coordinates is as follows.

$$SOC = \frac{\int_0^t I \, dt}{Q_{max}}$$

$$, \quad (2)$$

Based on the above calculation method, EMF~SOC curves under different temperature conditions can be calculated and obtained.

Accordingly, a method for establishing the internal resistance database by means of the representational charging curves obtained through a representational test and the EMF curve obtained through normalization as set forth in the above embodiment is as follows.

The overpotential $\eta(SOC)$ of the battery is calculated based on the representational charging curves and the EMF curve obtained at different temperatures:

$$\eta(SOC) = V(SOC) - EMF(SOC), (3)$$

A value of the internal resistance of the battery is calculated based on a value of the overpotential:

$$\bar{R}(SOC) = \frac{\eta(SOC)}{I}, (4)$$

The values of the internal resistance at different temperatures, currents, and SOCs can be calculated in accordance with equation (4) to establish a standard internal resistance database.

In step S103, calculate an actual capacity and an initial SOC of the battery cell based on the actual internal resistance and the reference internal resistance of the battery cell under the any charging condition, and calculate an actual SOC of the battery cell during charging using the actual capacity and the initial SOC.

The calculating the actual capacity and the initial SOC of the battery cell based on the actual internal resistance and the reference internal resistance of the battery cell under the any charging condition includes: calculating a root-mean-square error between the actual internal resistance and the reference internal resistance of the battery cell under the any charging condition; and determining an objective function based on the root-mean-square error, and finding an optimal solution to the objective function using a least squares method to obtain the actual capacity and the initial SOC of the battery cell.

It should be understood that, according to the embodiments of the present disclosure, a mathematical relationship between the root-mean-square error and variables such as a capacity of the battery cell can be established through calculating the root-mean-square error between the actual internal resistance and the reference internal resistance. The actual capacity and the initial SOC of the battery cell are optimized and calculated through the least squares method using the root-mean-square error as the objective function.

In an embodiment of the present disclosure, calculating the root-mean-square error between the actual internal resistance and the reference internal resistance includes: establishing an expression for an internal resistance, the SOC, and a capacity of the battery cell; and calculating the root-mean-square error between the actual internal resistance and the reference internal resistance based on the expression.

Specifically, steps for calculating the root-mean-square error between the actual internal resistance and the reference internal resistance are as follows. FIG. 4 illustrates a charging current curve and a corresponding voltage curve of an LFP battery cell under an actual charging condition.

The SOC of the battery cell numbered i at a start time point of charging is denoted as $x_0^i$, and the capacity of the battery cell numbered i is denoted as $Q_0^i$. The SOC of the battery cell i during charging can be calculated using the following equation:

$$x^i = x_0^i + \frac{\int_0^t I dt}{Q_0^i}, (5)$$

In this case, the internal resistance of the battery cell i can be calculated using the following equation:

$$R(x^i) = \frac{V(x^i) - EMF(x^i)}{I}, (6)$$

By substituting equation (5) into equation (6), a functional relationship between the internal resistance and the capacity $Q_0^i$ of the battery cell i is obtained as:

$$R\left(x_0^i + \frac{\int_0^t I\,dt}{Q_0^i}\right) = \frac{V\left(x_0^i + \frac{\int_0^t I\,dt}{Q_0^i}\right) - EMF\left(x_0^i + \frac{\int_0^t I\,dt}{Q_0^i}\right)}{I}, (7)$$

The root-mean-square error between the actual internal resistance and the reference internal resistance of the battery cell i is calculated:

$$RLS^i = \sqrt{\sum_{j=1}^{N}\left(R\left(x_0^i + \frac{I_j \Delta t}{Q_0^i}\right) - \bar{R}\left(x_0^i + \frac{I_j \Delta t}{Q_0^i}\right)\right)^2}, (8)$$

In equation (8), j represents a j-th sampling point of current I, and N represents a total number of sampling points of current I.

Optimal values of $Q_0^i$ and $x_0^i$ can be obtained through finding a minimum value of equation (8), which represent the actual capacity and the initial SOC of the battery cell i, respectively.

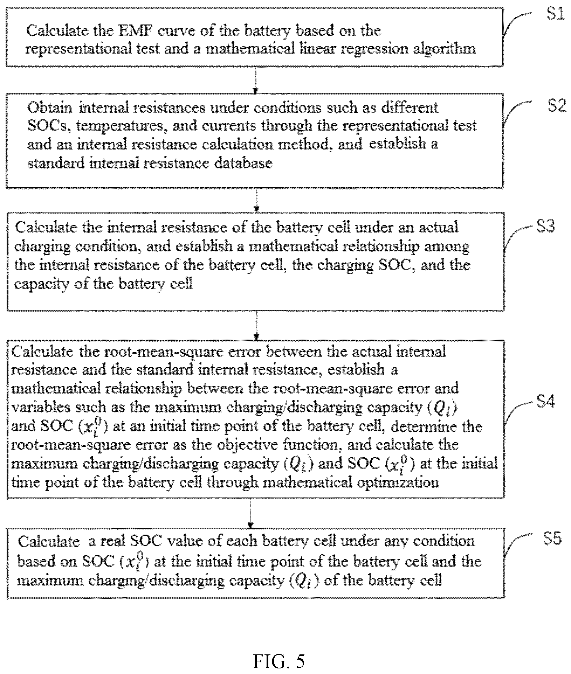

The method for estimating the SOC of the capacity of the single battery cell according to the embodiments of the present disclosure is illustrated below by means of a specific embodiment. A process of the method is illustrated in FIG. 5 by taking the battery cell of the LFP battery pack as an example. The process includes the following steps.

In step S1, calculate the EMF curve of the battery based on the representational test and a mathematical linear regression algorithm.

1. An LFP charging representational test matrix is constructed.

The charging test matrix is constructed from the two dimensions of temperature and charging current based on a performance reference table of the LFP battery cell, as illustrated in Table 2, which is a charging representational test matrix table.

Table 2

| Temperature | -20°C | -10°C | 0°C | 10°C | 20°C | 30°C | 40°C | 50°C |
|---|---|---|---|---|---|---|---|---|
| Charging current | 0.02C | 0.02C | 0.05C | 0.1C | 0.1C | 0.1C | 0.1C | 0.1C |
| | 0.05C | 0.05C | 0.1C | 0.2C | 0.2C | 0.2C | 0.2C | 0.2C |
| | 0.1C | 0.1C | 0.2C | 0.3C | 0.3C | 0.3C | 0.3C | 0.3C |
| | - | - | 0.3C | 0.5C | 0.5C | 0.5C | 0.5C | 0.5C |
| | - | - | - | - | 1C | 1C | 1C | 1C |
| | - | - | - | - | 2C | 2C | 1.5C | - |
| Discharging current | 0.1C | 0.1C | 0.2C | 0.3C | 0.3C | 0.3C | 0.3C | 0.3C |

2. A representational charging voltage curve is obtained using a representational test method.

By taking representational charging at 20°C as an example, the test method is as follows:

A. Discharge with a constant current 0.3C to a cut-off voltage.
B. Let stand for 1 hour.
C. Charge with a constant current 0.1C to the cut-off voltage, and record a voltage curve.
D. Let stand for 1 hour.
E. Discharge with the constant current 0.3C to the cut-off voltage.

F. Let stand for 1 hour.
G. Repeat steps C to F, using charging currents 0.2C, 0.3C, 0.5C, 1C, and 2C sequentially.
H. Calculate the EMF curve.

Subsequent to the obtaining the voltage curves under the different charging rates, the linear regression algorithm is used to calculate the electro motive force curve of the battery, which is calculated as follows.

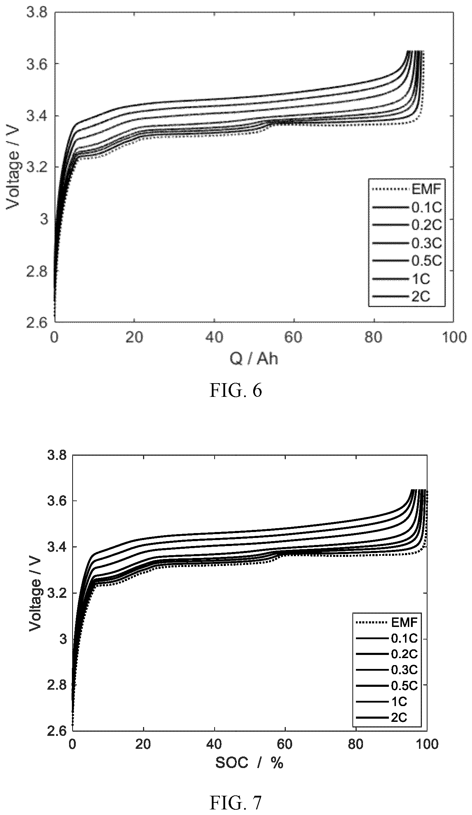

The charging voltage curves obtained under the different charging current conditions are illustrated in FIG. 6. The charging capacity of the battery is 92Ah when the battery is charged with a current of 0.1C to the cut-off voltage. The curves in FIG. 6 are divided into 100 grids based on Δq=92Ah/100=0.92Ah. In each grid, the voltage and the current satisfy equation (1). The coefficients in equation (1) are solved using the numerical method. Voltage values when the current is 0 are calculated through interpolation and extrapolation. These voltage values are connected to obtain a curve illustrated by a dotted line in FIG. 6. The dotted line is the EMF curve of the battery. The EMF curve corresponds to a maximum capacity value, which is denoted as $Q_{max}$. In this embodiment, for the LFP battery, $Q_{max}$=92.5 Ah.

The curves in FIG. X are normalized based on $Q_{max}$, in such a manner that V~Q curves are converted to V~SOC curves, as illustrated in FIG. 7. Based on the above method, EMF~SOC curves under all temperature conditions can be calculated and obtained.

In step S2, obtain internal resistances under conditions such as different SOCs, temperatures, and currents through the representational test and an internal resistance calculation method, and establish a standard internal resistance database.

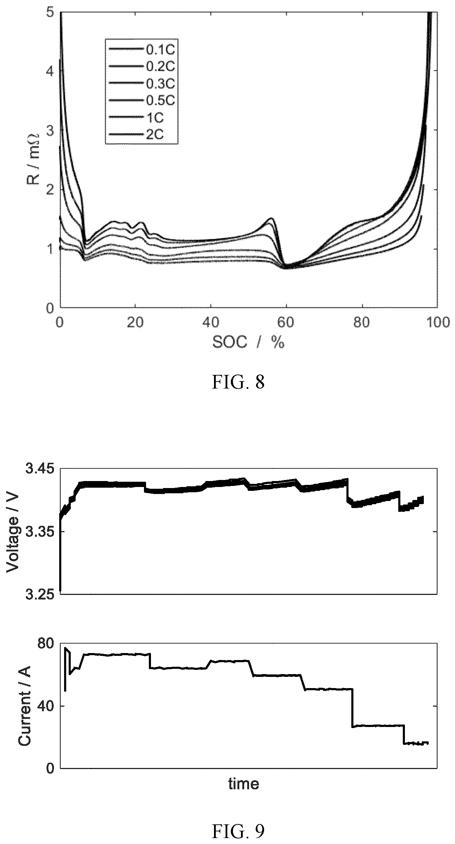

The overpotential η(SOC) of the battery is calculated based on the representational charging curves and the EMF curves obtained at the different temperatures in accordance with equation (3). Values of the internal resistance under different temperatures, currents, and SOCs are calculated based on equation (4). The standard internal resistance database is established. FIG. 8 illustrates internal resistance curves of an LFP battery at 20°C under different current conditions.

In step S3, calculate the internal resistance of the battery cell under an actual charging condition, and establish a mathematical relationship among the internal resistance of the battery cell, the charging SOC, and the capacity of the battery cell.

The SOC of the battery cell numbered 1 in the LFP battery pack at a start time point is denoted as $x_0^1$, and the capacity of the battery cell numbered 1 is denoted as $Q_0^1$. The SOC of the battery cell 1 during charging can be calculated using the following equation:

$$x^1 = x_0^1 + \frac{\int_0^t I \, dt}{Q_0^1} \text{, (9)}$$

According to equation (7), the mathematical relationship among the internal resistance of the battery cell 1, the SOC, and the capacity of the battery cell can be expressed as:

$$R\left(x_0^1 + \frac{\int_0^t I \, dt}{Q_0^1}\right) = \frac{V\left(x_0^1 + \frac{\int_0^t I \, dt}{Q_0^1}\right) - EMF\left(x_0^1 + \frac{\int_0^t I \, dt}{Q_0^1}\right)}{I} \text{, (10)}$$

In step S4, calculate the root-mean-square error between the actual internal resistance and the standard internal resistance (the reference internal resistance), establish a mathematical relationship between the root-mean-square error and variables such as the capacity of the battery cell, determine the root-mean-square error as the objective function, and calculate the capacity of the battery cell through the least squares mathematical optimization.

FIG. 9 illustrates a charging current curve and a corresponding voltage curve of an LFP battery pack under an actual charging condition. The root-mean-square error between the actual internal resistance and the standard internal resistance of the battery cell 1 is calculated based on the charging current curve and the voltage curve illustrated in FIG. 9.

$$RLS^1 = \sqrt{\sum_{j=1}^{N}\left(R\left(x_0^1 + \frac{I_j \Delta t}{Q_0^i}\right) - \bar{R}\left(x_0^1 + \frac{I_j \Delta t}{Q_0^1}\right)\right)^2}, (11)$$

In equation (11), j represents a j-th sampling point of current I, and N represents a total number of sampling points of current I. Optimal values of the capacity $Q_0^1$ and the initial $SOC\, x_0^1$ of the battery cell can be obtained through finding a minimum value of equation (11).

With the same method, capacities and initial SOCs of battery cells numbered from 2 to 104 in the LFP battery pack can be obtained, as illustrated in Table 3 and Table 4. Table 3 is a capacity table of all battery cells in the LFP battery pack. Table 4 is an initial SOC table of all battery cells in the LFP battery pack.

Table 3

| Cell No. | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|
| capacity /Ah | 91 .1 5 | 91. 6 | 91. 45 | 91 | 92. 03 | 90. 95 | 91. 3 | 91. 25 | 91. 23 | 90. 75 | 92. 12 | 92. 25 | 90. 91 | 91. 5 | 91. 62 |
| Cell No. | 16 | 17 | 18 | 19 | 20 | 21 | 22 | 23 | 24 | 25 | 26 | 27 | 28 | 29 | 30 |
| Capacit y/Ah | 91 .3 | 91. 32 | 91. 62 | 91. 41 | 91. 25 | 91. 63 | 91. 74 | 91. 54 | 91. 52 | 91. 1 | 91. 36 | 91 | 91. 44 | 91. 25 | 91. 21 |
| Cell No. | 31 | 32 | 33 | 34 | 35 | 36 | 37 | 38 | 39 | 40 | 41 | 42 | 43 | 44 | 45 |
| capacity /Ah | 91 .6 6 | 91. 85 | 91. 75 | 91. 94 | 91. 69 | 92. 2 | 92. 12 | 91. 05 | 90. 98 | 89. 6 | 90. 65 | 90. 78 | 91. 63 | 90. 76 | 90. 65 |
| Cell No. | 46 | 47 | 48 | 49 | 50 | 51 | 52 | 53 | 54 | 55 | 56 | 57 | 58 | 59 | 60 |
| Capacit y/Ah | 91 .3 3 | 91. 65 | 91. 32 | 91. 62 | 91. 41 | 91. 25 | 92. 12 | 91. 05 | 90. 98 | 90. 75 | 92. 12 | 92. 25 | 91. 74 | 91. 54 | 91. 52 |
| Cell No. | 61 | 62 | 63 | 64 | 65 | 66 | 67 | 68 | 69 | 70 | 71 | 72 | 73 | 74 | 75 |
| Capacit y/Ah | 91 .6 4 | 91. 25 | 91. 63 | 91 | 91. 44 | 91. 25 | 91. 21 | 91. 41 | 91. 25 | 92. 12 | 91. 05 | 90. 98 | 90. 5 | 89. 96 | 90. 96 |
| Cell No. | 76 | 77 | 78 | 79 | 80 | 81 | 82 | 83 | 84 | 85 | 86 | 87 | 88 | 89 | 90 |
| Capacit y/Ah | 90 .6 5 | 90. 78 | 91. 63 | 91. 69 | 92. 2 | 92. 12 | 91. 05 | 91. 75 | 91. 94 | 91. 74 | 91. 54 | 91. 52 | 90. 75 | 92. 12 | 90. 91 |
| Cell No. | 91 | 92 | 93 | 94 | 95 | 96 | 97 | 98 | 99 | 100 | 101 | 102 | 103 | 104 | |
| Capacit y/Ah | 91 .4 1 | 91. 25 | 92. 12 | 91. 05 | 91. 62 | 91. 41 | 91. 25 | 90. 98 | 90. 75 | 91. 32 | 91. 62 | 91. 41 | 91. 25 | 91. 66 | |

EP 4 564 029 A1

Table 4

| Cell No. | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|
| initial SOC | 0.15 | 0.14 | 0.15 | 0.15 | 0.14 | 0.15 | 0.15 | 0.15 | 0.13 | 0.15 | 0.15 | 0.14 | 0.13 | 0.14 | 0.13 |
| Cell No. | 16 | 17 | 18 | 19 | 20 | 21 | 22 | 23 | 24 | 25 | 26 | 27 | 28 | 29 | 30 |
| initial SOC | 0.13 | 0.14 | 0.15 | 0.15 | 0.14 | 0.15 | 0.13 | 0.14 | 0.13 | 0.15 | 0.15 | 0.13 | 0.14 | 0.13 | 0.15 |
| Cell No. | 31 | 32 | 33 | 34 | 35 | 36 | 37 | 38 | 39 | 40 | 41 | 42 | 43 | 44 | 45 |
| initial SOC | 0.15 | 0.13 | 0.14 | 0.13 | 0.15 | 0.15 | 0.15 | 0.13 | 0.14 | 0.13 | 0.15 | 0.14 | 0.13 | 0.12 | 0.13 |
| Cell No. | 46 | 47 | 48 | 49 | 50 | 51 | 52 | 53 | 54 | 55 | 56 | 57 | 58 | 59 | 60 |
| initial SOC | 0.14 | 0.14 | 0.15 | 0.15 | 0.15 | 0.15 | 0.14 | 0.15 | 0.15 | 0.15 | 0.15 | 0.15 | 0.15 | 0.14 | 0.13 |
| Cell No. | 61 | 62 | 63 | 64 | 65 | 66 | 67 | 68 | 69 | 70 | 71 | 72 | 73 | 74 | 75 |
| initial SOC | 0.15 | 0.14 | 0.14 | 0.15 | 0.14 | 0.15 | 0.15 | 0.13 | 0.14 | 0.15 | 0.15 | 0.14 | 0.15 | 0.15 | 0.13 |
| Cell No. | 76 | 77 | 78 | 79 | 80 | 81 | 82 | 83 | 84 | 85 | 86 | 87 | 88 | 89 | 90 |
| initial SOC | 0.15 | 0.14 | 0.13 | 0.15 | 0.14 | 0.15 | 0.15 | 0.13 | 0.14 | 0.15 | 0.15 | 0.14 | 0.13 | 0.15 | 0.15 |
| Cell No. | 91 | 92 | 93 | 94 | 95 | 96 | 97 | 98 | 99 | 100 | 101 | 102 | 103 | 104 | |
| initial SOC | 0.15 | 0.14 | 0.14 | 0.15 | 0.14 | 0.15 | 0.15 | 0.13 | 0.14 | 0.15 | 0.15 | 0.15 | 0.15 | 0.14 | |

In step S5, calculate a real SOC value of each battery cell based on an initial SOC value and a capacity value of each battery cell.

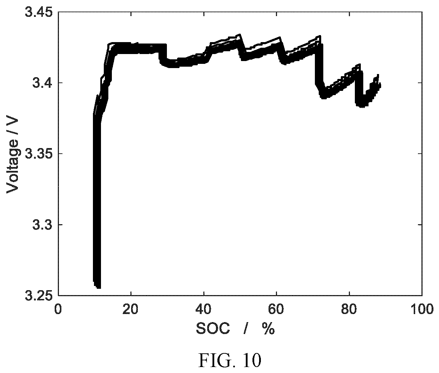

A real SOC of the battery cell from the time point of charging up to a time point t is calculated through substituting the capacity $Q_0^1$ and the initial $SOCx_0^1$ of each battery cell in Table 3 and Table 4 into equation (5). Based on the real SOC value of each battery cell, the charging curve illustrated in FIG. 9 can be adjusted to that in FIG. 10. FIG. 10 illustrates a variation range of a SOC value of each battery cell and corresponding voltage variation curves during actual charging of an LFP battery pack.

With the method for estimating the SOC of the battery cell according to the embodiments of the present disclosure, the actual capacity and the initial SOC of any battery cell can be calculated through comparing the actual internal resistance of the battery cell with the reference internal resistance of the battery cell, and the actual SOC is calculated based on the actual capacity and the initial SOC. Since the pre-established internal resistance database is used, the reference internal resistance of the battery cell under the any charging condition can be obtained, which prevents the user charging condition and the battery system from affecting a calculation result, and is effectively applicable to various battery systems, realizing an accurate calculation of the SOC of the battery cell.

Further, another method for estimating a SOC of a battery cell is provided according to the embodiments of the present disclosure. The previous embodiment focuses on illustrating a process of estimating the SOC of the battery cell from an online application perspective, while the next embodiment focuses on illustrating a process of estimating the SOC of the battery cell from an offline application perspective. For any aspects not fully detailed in one embodiment, reference can be made to another embodiment for supplementary information.

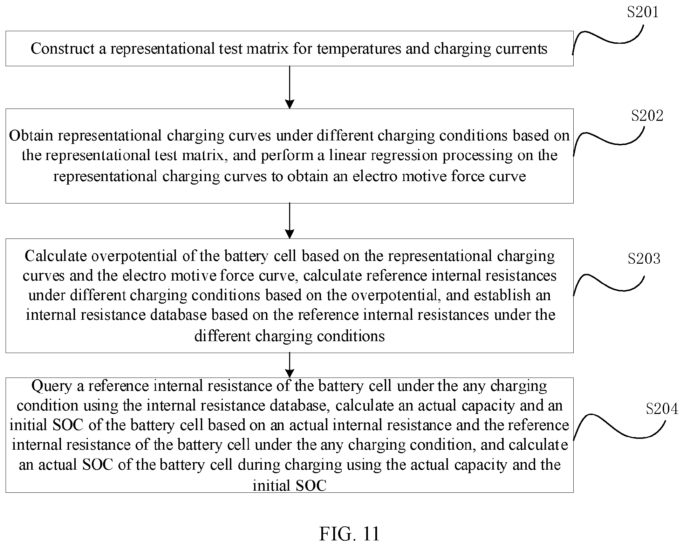

FIG. 11 is a flowchart of a method for estimating a SOC of a battery cell according to another embodiment of the present disclosure.

As illustrated in FIG. 11, the method for estimating the SOC of the battery cell is applied in a server and includes following steps.

In step S201, construct a representational test matrix for temperatures and charging currents.

The method for constructing the representational test matrix has been set forth in the above embodiments, reference to which can be made to relevant description in the above embodiments. Details thereof will be omitted here for simplicity.

In step S202, obtain representational charging curves under different charging conditions based on the representational test matrix, and perform a linear regression processing on the representational charging curves to obtain an electro motive force curve.

It should be understood that, according to the embodiments of the present disclosure, the representational charging curves under the different charging conditions can be obtained through the representational test matrix. The linear regression processing is performed on the representational charging curves to obtain the electro motive force curve. The method for the calculation has been described in the above embodiments, and thus details thereof will be omitted here.

In step S203, calculate overpotential of the battery cell based on the representational charging curves and the electro motive force curve, calculate reference internal resistances under different charging conditions based on the overpotential, and establish an internal resistance database based on the reference internal resistances under the different charging conditions.

The methods for calculating the overpotential of the battery cell and the reference internal resistance under the different charging conditions have been described in the above embodiments, and thus details thereof will be omitted here.

In step S204, query a reference internal resistance of the battery cell under the any charging condition using the internal resistance database, calculate an actual capacity and an initial SOC of the battery cell based on an actual internal resistance and the reference internal resistance of the battery cell under the any charging condition, and calculate an actual SOC of the battery cell during charging using the actual capacity and the initial SOC.

It should be understood that, according to the embodiments of the present disclosure, the actual capacity and the initial SOC of the any battery cell are calculated based on the actual internal resistance and the reference internal resistance, and the actual SOC of the battery cell during charging is calculated using the actual capacity and the initial SOC.

With the method for estimating the SOC of the battery cell according to the embodiments of the present disclosure, the actual capacity and the initial SOC of any battery cell can be calculated through comparing the actual internal resistance of the battery cell with the reference internal resistance of the battery cell. The actual SOC is calculated based on the actual capacity and the initial SOC. The reference internal resistance of the battery cell under the any charging condition is obtained using the pre-established internal resistance database, which prevents the user charging condition and the battery system from affecting the calculation result, and is effectively applicable to various battery systems, realizing the accurate calculation of the SOC of the battery cell.

A device for estimating a SOC of a battery cell according to an embodiment of the present disclosure is described below with reference to the figures.

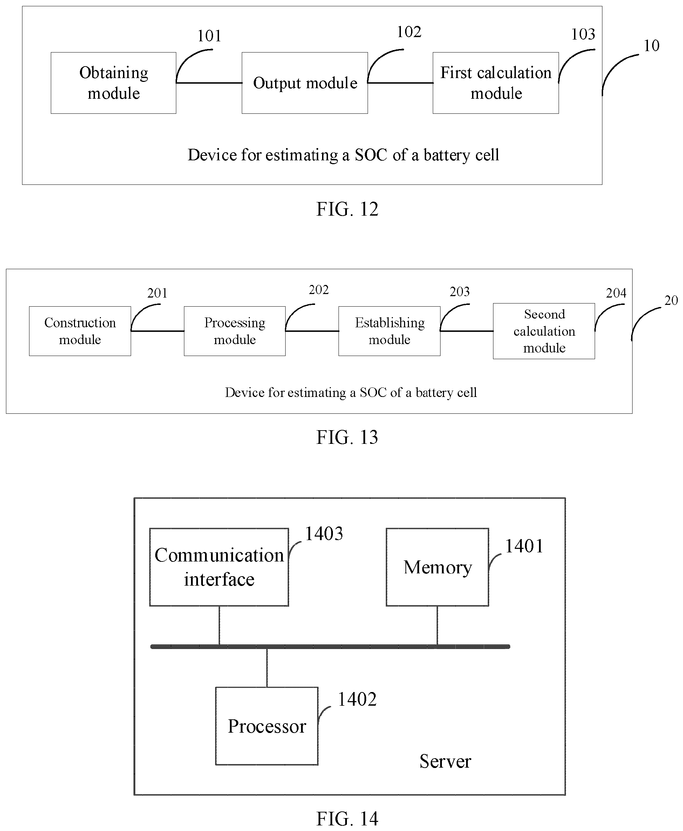

FIG. 12 is a block diagram showing a device for estimating a SOC of a battery cell according to an embodiment of the present disclosure.

As illustrated in FIG. 12, a device 10 for estimating a SOC of a battery cell is applied in a server and includes an obtaining module 101, an output module 102, and a first calculation module 103.

Specifically, the obtaining module 101 is configured to obtain an actual internal resistance of any battery cell under any charging condition. The output module 102 is configured to query a pre-established internal resistance database using the any charging condition as an index to output a reference internal resistance of the battery cell under the any charging condition. The first calculation module 103 is configured to calculate an actual capacity and an initial SOC of the battery cell based on the actual internal resistance and the reference internal resistance of the battery cell under the any charging condition, and calculate an actual SOC of the battery cell during charging using the actual capacity and the initial SOC.

In an embodiment of the present disclosure, the first calculation module 103 is further configured to: calculate a root-mean-square error between the actual internal resistance and the reference internal resistance of the battery cell under the any charging condition; and determine an objective function based on the root-mean-square error, and finding an optimal solution to the objective function using a least squares method to obtain the actual capacity and the initial SOC of the battery cell.

Further, the first calculation module 103 is further configured to: establish an expression for an internal resistance, the SOC, and a capacity of the battery cell; and calculate the root-mean-square error between the actual internal resistance and the reference internal resistance based on the expression.

In an embodiment of the present disclosure, the device 10 of the present disclosure further includes a third calculation module.

The third calculation module is configured to, prior to the querying the pre-established internal resistance database: construct a representational test matrix for temperatures and charging currents; obtain representational charging curves under different charging conditions based on the representational test matrix, and perform a linear regression processing on the representational charging curves to obtain an electro motive force curve; and calculate overpotential of the battery cell based on the representational charging curves and the electro motive force curve, calculate reference internal resistances under different charging conditions based on the overpotential, and establish the internal resistance database based on the reference internal resistances under the different charging conditions.

In an embodiment of the present disclosure, the third calculation module is further configured to: obtain a maximum charging capacity corresponding to the representational charging curves; determine a stepsize of a capacity interval corresponding to each charging voltage curve based on the maximum charging capacity, and divide the capacity interval into a plurality of grids based on the stepsize; and calculate, through interpolation and extrapolation, a voltage value in each of the plurality of grids when a current in each of the plurality of grids is a predetermined value, and generate the electro motive force curve subsequent to normalizing all voltage values.

In an embodiment of the present disclosure, the third calculation module is further configured to: discharge to a predetermined cut-off voltage under a first charging condition, and let stand for a first predetermined duration; discharge to the predetermined cut-off voltage under a second charging condition, record the representational charging curve, and let stand for a second predetermined duration; and discharge to the predetermined cut-off voltage under the first charging condition, and perform a charging test under a next charging condition until all charging conditions are tested, to obtain the representational charging curves under the different charging conditions.

In an embodiment of the present disclosure, the charging condition includes one or more of temperature, charging rate, current, and SOC.

It should be noted that the above explanatory description of the embodiment of the method for estimating the SOC of the battery cell is also applicable to the device for estimating the SOC of the battery cell according to this embodiment, and thus details thereof will be omitted here.

With the device for estimating the SOC of the battery cell according to the embodiments of the present disclosure, the actual capacity and the initial SOC of the any battery cell can be calculated through comparing the actual internal resistance of the battery cell with the reference internal resistance of the battery cell, and the actual SOC is calculated based on the actual capacity and the initial SOC. Since the pre-established internal resistance database is used, the reference internal resistance of the battery cell under the any charging condition can be obtained, which prevents the user charging condition and the battery system from affecting the calculation result, and is effectively applicable to various battery systems, realizing the accurate calculation of the SOC of the battery cell.

FIG. 13 is a schematic diagram of a device for estimating a SOC of a battery cell according to another embodiment of the present disclosure.

As illustrated in FIG. 13, a device 20 for estimating a SOC of a battery cell is applied in a server and includes a construction module 201, a processing module 202, an establishing module 203, and a second calculation module 204.

The construction module 201 is configured to construct a representational test matrix for temperatures and charging currents. The processing module 202 is configured to obtain representational charging curves under different charging conditions based on the representational test matrix, and perform a linear regression processing on the representational charging curves to obtain an electro motive force curve. The establishing module 203 is configured to calculate overpotential of the battery cell based on the representational charging curves and the electro motive force curve, calculate reference internal resistances under different charging conditions based on the overpotential, and establish an internal resistance database based on the reference internal resistances under the different charging conditions. The second calculation module 204 is configured to query a reference internal resistance of the battery cell under the any charging condition using the internal resistance database, calculate an actual capacity and an initial SOC of the battery cell based on an actual internal resistance and the reference internal resistance of the battery cell under the any charging condition, and calculate an actual SOC corresponding to the battery cell during charging using the actual capacity and the initial SOC.

It should be noted that the above explanatory description of the embodiment of the method for estimating the SOC of the battery cell is also applicable to the device for estimating the SOC of the battery cell according to this embodiment, and thus details thereof will be omitted here.

With the device for estimating the SOC of the battery cell according to the embodiments of the present disclosure, the actual capacity and the initial SOC of any battery cell can be calculated through comparing the actual internal resistance of the battery cell with the reference internal resistance of the battery cell. The actual SOC is calculated based on the actual capacity and the initial SOC. The reference internal resistance of the battery cell under the any charging condition is obtained using the pre-established internal resistance database, which prevents the charging condition of the user and the battery system from affecting the calculation result, and is effectively applicable to various battery systems, realizing the accurate calculation of the SOC of the battery cell.

FIG. 14 is a block diagram showing a structure of a server according to an embodiment of the present disclosure. The server may include a memory 1401; a processor 1402; and a computer program stored in the memory 1401 and executable on the processor 1402.

The processor 1402, when executing the computer program, implements the method for estimating the SOC of the battery cell according to the above embodiments.

Further, the server further includes a communication interface 1403 configured to allow communication between the memory 1401 and the processor 1402.

The memory 1401 is configured to store a computer program executable by the processor 1402.

The memory 1401 may include a high-speed Random Access Memory, RAM, and may also include a non-volatile memory, such as at least one disk memory.

When the memory 1401, the processor 1402, and the communication interface 1403 are implemented independently, the communication interface 1403, the memory 1401, and the processor 1402 can be connected to each other via a bus and communicate with each other. The bus can be an Industry Standard Architecture, ISA, bus, a Peripheral Component, PCI, bus, or an Extended Industry Standard Architecture, EISA, bus, etc. The bus can be categorized into an address bus, a data bus, a control bus, etc. For ease of representation, only one thick line is used in FIG. 14, but it does not mean that there is only one bus or one type of bus.

Optionally, in a specific implementation, when the memory 1401, the processor 1402, and the communication interface 1403 are integrated on a single chip, the memory 1401, the processor 1402, and the communication interface 1403 can communicate with each other via an internal interface.

The processor 1402 can be a Central Processing Unit, CPU, an Application Specific Integrated Circuit, ASIC, or one or more integrated circuits configured to implement the embodiments of the present disclosure.

A computer-readable storage medium is further provided according to an embodiment of the present disclosure. The computer-readable storage medium stores a computer program. The computer program, when executed by a processor, implements the method for estimating the SOC of the battery cell as described above.

Reference throughout this specification to "an embodiment", "some embodiments", "an example", "a specific example", or "some examples" means that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Further, the particular features, structures, materials, or characteristics may be combined in any suitable manner in one or N embodiments or examples. In addition, different embodiments or examples and features of different embodiments or examples described in the specification may be combined by those skilled in the art without mutual contradiction.

In addition, the terms "first" and "second" are only used for descriptive purposes, and cannot be understood as indicating or implying relative importance or implicitly indicating the number of indicated technical features. Therefore, the features associated with "first" and "second" may explicitly or implicitly include at least one of the features. In the description of the present disclosure, "N" means at least two, such as two, three, etc., unless otherwise specifically defined.

Any process or method described in a flowchart or described herein in other ways may be understood to include one or N modules, segments, or portions of codes of executable instructions for achieving specific logical functions or steps in the process. The scope of a preferred embodiment of the present disclosure includes other implementations. A function may be performed not in a sequence shown or discussed, including a substantially simultaneous manner or a reverse sequence based on the function involved, which should be understood by those skilled in the art to which the embodiments of the present disclosure belong.

It should be understood that each part of the present disclosure may be realized by hardware, software, firmware, or a combination thereof. In the above embodiments, N steps or methods may be realized by software or firmware stored in the memory and executed by an appropriate instruction execution system. For example, when it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a Programmable Gate Array, a Field Programmable Gate Array, etc.

It should be understood by those skilled in the art that all or a part of the steps carried by the method in the above-described embodiments may be completed by relevant hardware instructed by a program. The program may be stored in a computer-readable storage medium. When the program is executed, one or a combination of the steps of the method in the above-described embodiments may be included.

Although embodiments of the present disclosure have been shown and described above, it should be understood that above embodiments are merely exemplary, and cannot be construed to limit the present disclosure. For those skilled in the art, changes, alternatives, and modifications can be made to the embodiments without departing from the scope of the present disclosure.

**Claims**

1. A method for estimating a State of Charge, SOC, of a battery cell, the method being applied in a server and comprising:

   obtaining an actual internal resistance of the battery cell under any charging condition;
   querying a pre-established internal resistance database using the any charging condition as an index, to output a reference internal resistance of the battery cell under the any charging condition; and
   calculating an actual capacity and an initial SOC of the battery cell based on the actual internal resistance and the reference internal resistance of the battery cell under the any charging condition, and calculating an actual SOC of the battery cell during charging using the actual capacity and the initial SOC.

2. The method for estimating the SOC of the battery cell according to claim 1, wherein said calculating the actual capacity and the initial SOC of the battery cell based on the actual internal resistance and the reference internal resistance comprises:

calculating a root-mean-square error between the actual internal resistance and the reference internal resistance of the battery cell under the any charging condition; and
determining an objective function based on the root-mean-square error, and finding an optimal solution to the objective function using a least squares method to obtain the actual capacity and the initial SOC of the battery cell.

3. The method for estimating the SOC of the battery cell according to claim 2, wherein said calculating the root-mean-square error between the actual internal resistance and the reference internal resistance of the battery cell under the any charging condition comprises:

establishing an expression for an internal resistance, the SOC, and a capacity of the battery cell; and
calculating the root-mean-square error between the actual internal resistance and the reference internal resistance based on the expression.

4. The method for estimating the SOC of the battery cell according to claim 1, further comprising, prior to said querying the pre-established internal resistance database:

constructing a representational test matrix for temperatures and charging currents;
obtaining representational charging curves under different charging conditions based on the representational test matrix, and performing a linear regression processing on the representational charging curves to obtain an electro motive force curve; and
calculating overpotential of the battery cell based on the representational charging curves and the electro motive force curve, calculating reference internal resistances under different charging conditions based on the overpotential, and establishing the internal resistance database based on the reference internal resistances under the different charging conditions.

5. The method for estimating the SOC of the battery cell according to claim 4, wherein said performing the linear regression processing on the representational charging curves to obtain the electro motive force curve comprises:

obtaining a maximum charging capacity corresponding to the representational charging curves;
determining a stepsize of a capacity interval corresponding to each charging voltage curve based on the maximum charging capacity, and dividing the capacity interval into a plurality of grids based on the stepsize; and
calculating, through interpolation and extrapolation, a voltage value in each of the plurality of grids when a current in each of the plurality of grids is a predetermined value, and generating the electro motive force curve subsequent to normalizing all voltage values.

6. The method for estimating the SOC of the battery cell according to claim 4, wherein said obtaining the representational charging curves under the different charging conditions based on the representational test matrix comprises:

discharging to a predetermined cut-off voltage under a first charging condition, and letting stand for a first predetermined duration;
discharging to the predetermined cut-off voltage under a second charging condition, recording the representational charging curve, and letting stand for a second predetermined duration; and
discharging to the predetermined cut-off voltage under the first charging condition, and performing a charging test under a next charging condition until all charging conditions are tested, to obtain the representational charging curves under the different charging conditions.

7. The method for estimating the SOC of the battery cell according to any one of claims 1 to 6, wherein the charging condition comprises one or more of temperature, charging rate, current, and SOC.

8. A method for estimating a State of Charge, SOC, of a battery cell, the method being applied in a server and comprising:

constructing a representational test matrix for temperatures and charging currents;
obtaining representational charging curves under different charging conditions based on the representational test matrix, and performing a linear regression processing on the representational charging curves to obtain an electro motive force curve;
calculating overpotential of the battery cell based on the representational charging curves and the electro motive force curve, calculating reference internal resistances under different charging conditions based on the overpotential, and establishing an internal resistance database based on the reference internal resistances under the different charging conditions; and

querying a reference internal resistance of the battery cell under the any charging condition using the internal resistance database, calculating an actual capacity and an initial SOC of the battery cell based on an actual internal resistance and the reference internal resistance of the battery cell under the any charging condition, and calculating an actual SOC of the battery cell during charging using the actual capacity and the initial SOC.

9. A device for estimating a State of Charge, SOC, of a battery cell, the device being applied in a server and comprising:

an obtaining module configured to obtain an actual internal resistance of any battery cell under any charging condition;

an output module configured to query a pre-established internal resistance database using the any charging condition as an index to output a reference internal resistance under the any charging condition; and

a first calculation module configured to calculate an actual capacity and an initial SOC of the battery cell based on the actual internal resistance and the reference internal resistance of the battery cell under the any charging condition, and calculate an actual SOC of the battery cell during charging using the actual capacity and the initial SOC.

10. A device for estimating a State of Charge, SOC, of a battery cell, the device being applied in a server and comprising:

a construction module configured to construct a representational test matrix for temperatures and charging currents;

a processing module configured to obtain representational charging curves under different charging conditions based on the representational test matrix, and perform a linear regression processing on the representational charging curves to obtain an electro motive force curve;

an establishing module configured to calculate overpotential of the battery cell based on the representational charging curves and the electro motive force curve, calculate reference internal resistances under different charging conditions based on the overpotential, and establish an internal resistance database based on the reference internal resistances under the different charging conditions; and

a second calculation module configured to query a reference internal resistance under the any charging condition using the internal resistance database, calculate an actual capacity and an initial SOC of the battery cell based on an actual internal resistance and the reference internal resistance under the any charging condition, and calculate an actual SOC corresponding to the battery cell during charging using the actual capacity and the initial SOC.

11. A server, comprising:

a memory;
a processor; and
a computer program stored in the memory and executable on the processor,
wherein the processor, when executing the computer program, implements the method for estimating the SOC of the battery cell according to any one of claims 1 to 8.

12. A computer-readable storage medium having a computer program stored thereon, wherein the computer program, when executed by a processor, implements the method for estimating the SOC of the battery cell according to any one of claims 1 to 8.

EP 4 564 029 A1

<table>
<tr><td>Obtain an actual internal resistance of the battery cell under any charging condition</td><td>S101</td></tr>
</table>

↓

<table>
<tr><td>Query a pre-established internal resistance database using the any charging condition as an index to output a reference internal resistance of the battery cell under the any charging condition</td><td>S102</td></tr>
</table>

↓

<table>
<tr><td>Calculate an actual capacity and an initial SOC of the battery cell based on the actual internal resistance and the reference internal resistance of the battery cell under the any charging condition, and calculate an actual SOC of the battery cell during charging using the actual capacity and the initial SOC</td><td>S103</td></tr>
</table>

FIG. 1

FIG. 2

19

FIG. 3

FIG. 4

Calculate the EMF curve of the battery based on the representational test and a mathematical linear regression algorithm — S1

Obtain internal resistances under conditions such as different SOCs, temperatures, and currents through the representational test and an internal resistance calculation method, and establish a standard internal resistance database — S2

Calculate the internal resistance of the battery cell under an actual charging condition, and establish a mathematical relationship among the internal resistance of the battery cell, the charging SOC, and the capacity of the battery cell — S3

Calculate the root-mean-square error between the actual internal resistance and the standard internal resistance, establish a mathematical relationship between the root-mean-square error and variables such as the maximum charging/discharging capacity ($Q_i$) and SOC ($x_i^0$) at an initial time point of the battery cell, determine the root-mean-square error as the objective function, and calculate the maximum charging/discharging capacity ($Q_i$) and SOC ($x_i^0$) at the initial time point of the battery cell through mathematical optimization — S4

Calculate a real SOC value of each battery cell under any condition based on SOC ($x_i^0$) at the initial time point of the battery cell and the maximum charging/discharging capacity ($Q_i$) of the battery cell — S5

FIG. 5

FIG. 6

FIG. 7

FIG. 8

FIG. 9

FIG. 10

S201

Construct a representational test matrix for temperatures and charging currents

S202

Obtain representational charging curves under different charging conditions based on the representational test matrix, and perform a linear regression processing on the representational charging curves to obtain an electro motive force curve

S203

Calculate overpotential of the battery cell based on the representational charging curves and the electro motive force curve, calculate reference internal resistances under different charging conditions based on the overpotential, and establish an internal resistance database based on the reference internal resistances under the different charging conditions

S204

Query a reference internal resistance of the battery cell under the any charging condition using the internal resistance database, calculate an actual capacity and an initial SOC of the battery cell based on an actual internal resistance and the reference internal resistance of the battery cell under the any charging condition, and calculate an actual SOC of the battery cell during charging using the actual capacity and the initial SOC

FIG. 11

101

Obtaining module

102

Output module

103

First calculation module

10

Device for estimating a SOC of a battery cell

FIG. 12

201

Construction module

202

Processing module

203

Establishing module

204

Second calculation module

20

Device for estimating a SOC of a battery cell

FIG. 13

1403

Communication interface

1401

Memory

1402

Processor

Server

FIG. 14

## INTERNATIONAL SEARCH REPORT

| International application No. |
| --- |
| **PCT/CN2023/121481** |

**A. CLASSIFICATION OF SUBJECT MATTER**

G01R31/367(2019.01)i; G01R31/389(2019.01)i; G01R31/396(2019.01)i

According to International Patent Classification (IPC) or to both national classification and IPC

**B. FIELDS SEARCHED**

Minimum documentation searched (classification system followed by classification symbols)

IPC:G01R31

Documentation searched other than minimum documentation to the extent that such documents are included in the fields searched

Electronic data base consulted during the international search (name of data base and, where practicable, search terms used)

CNABS, CNTXT, CNKI, 万方, WANFANG: 电池, 电芯, 单体, 荷电状态, SOC, 实际, 真实, 测量, 实测, 内阻, 电阻, 参考, 基准, 理想, 理论, 标准, 容量, 电量, 均方根, 误差, 目标函数, 最小二乘法, 温度, 电流, 电压, 电势, 电动势, EMF, 曲线 VEN, USTXT, WOTXT, EPTXT: battery, core, cell, state of charge, SOC, practicality, real, detect, measure, test, resistance, reference, theoretical, standard, capacity, root mean square, error, target function, objective function, temperature, current, voltage, electromotive force, EMF, curve

**C. DOCUMENTS CONSIDERED TO BE RELEVANT**

| Category* | Citation of document, with indication, where appropriate, of the relevant passages | Relevant to claim No. |
| --- | --- | --- |
| PX | CN 116430241 A (DEEPBLUE AUTOMOTIVE TECHNOLOGIES CO., LTD.) 14 July 2023 (2023-07-14)<br>claims 1-12 | 1-12 |
| X | CN 115616421 A (CHONGQING CHANG'AN NEW ENERGY AUTOMOBILE TECHNOLOGY CO., LTD.) 17 January 2023 (2023-01-17)<br>description, paragraphs 78-146 | 1-12 |
| Y | CN 112415410 A (BYD CO., LTD.) 26 February 2021 (2021-02-26)<br>description, paragraphs 40-56 | 1, 7, 9, 11-12 |
| Y | CN 102830361 A (HYTERA COMMUNICATIONS CO., LTD.) 19 December 2012 (2012-12-19)<br>description, paragraphs 61-64 | 1, 7, 9, 11-12 |
| Y | WO 2013031558 A1 (SANYO ELECTRIC CO., LTD. et al.) 07 March 2013 (2013-03-07)<br>description, paragraphs 23-25 | 1, 7, 9, 11-12 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **31 January 2024** | **02 February 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/121481**

### C. DOCUMENTS CONSIDERED TO BE RELEVANT

| Category* | Citation of document, with indication, where appropriate, of the relevant passages | Relevant to claim No. |
|---|---|---|
| A | CN 115389959 A (CHANGSHA YOULI ELECTRIC DRIVE SYSTEM CO., LTD.) 25 November 2022 (2022-11-25) entire document | 1-12 |
| A | CN 106154171 A (TSINGHUA UNIVERSITY) 23 November 2016 (2016-11-23) entire document | 1-12 |
| A | CN 112986841 A (BYD CO., LTD.) 18 June 2021 (2021-06-18) entire document | 1-12 |
| A | JP 2007192726 A (NISSAN MOTOR CO., LTD.) 02 August 2007 (2007-08-02) entire document | 1-12 |

Form PCT/ISA/210 (second sheet) (July 2022)

## INTERNATIONAL SEARCH REPORT
### Information on patent family members

International application No.

**PCT/CN2023/121481**

| Patent document cited in search report | | | Publication date (day/month/year) | Patent family member(s) | | | Publication date (day/month/year) |
|---|---|---|---|---|---|---|---|
| CN | 116430241 | A | 14 July 2023 | None | | | |
| CN | 115616421 | A | 17 January 2023 | None | | | |
| CN | 112415410 | A | 26 February 2021 | None | | | |
| CN | 102830361 | A | 19 December 2012 | CN | 102830361 | B | 28 January 2015 |
| WO | 2013031558 | A1 | 07 March 2013 | JP | 2014211307 | A | 13 November 2014 |
| CN | 115389959 | A | 25 November 2022 | None | | | |
| CN | 106154171 | A | 23 November 2016 | CN | 106154171 | B | 05 February 2019 |
| CN | 112986841 | A | 18 June 2021 | CN | 112986841 | B | 15 July 2022 |
| JP | 2007192726 | A | 02 August 2007 | JP | 4816097 | B2 | 16 November 2011 |

Form PCT/ISA/210 (patent family annex) (July 2022)

**REFERENCES CITED IN THE DESCRIPTION**

**Patent documents cited in the description**

- CN 202310640069X